# EUROPEAN PATENT SPECIFICATION

(11) **EP 0 794 580 B1**
(45) Date of publication and mention of the grant of the patent: **11.06.2003**
(21) Application number: 97102345.2
(22) Date of filing: 13.02.1997
(51) Int. Cl.: H01L 41/107

(54) **Piezoelectric transformer**
Piezoelektrischer Transformator
Transformateur piézo-électrique

(30) Priority: 14.02.1996 JP 2691996; 14.02.1996 JP 2692096
(43) Date of publication of application: 10.09.1997
(73) Proprietor: MURATA MANUFACTURING CO., LTD., Nagaokakyo-shi Kyoto-fu 226 (JP)
(72) Inventor: Ogiso, Koji, Nagaokakyo-shi, Kyoto-fu (JP); Ando, Akira, Nagaokakyo-shi, Kyoto-fu (JP)
(74) Representative: Gossel, Hans K., Dipl.-Ing.

(56) References cited:
- EP-A- 0 720 246
- US-A- 5 440 195
- PATENT ABSTRACTS OF JAPAN vol. 095, no. 010, 30 November 1995 & JP 07 176805 A (WEST ELECTRIC CO LTD;OTHERS: 01), 14 July 1995,
- PATENT ABSTRACTS OF JAPAN vol. 096, no. 006, 28 June 1996 & JP 08 032137 A (AKIRA TOKUSHIMA;OTHERS: 01), 2 February 1996,
- PATENT ABSTRACTS OF JAPAN vol. 017, no. 466 (E-1421), 25 August 1993 & JP 05 110368 A (TOKIN CORP), 30 April 1993,

## Description

### FIELD OF THE INVENTION

The present invention relates to a piezoelectric transformer, especially a piezoelectric transformer comprising a driving section having a plurality of driving electrodes with a first piezoelectric member, contacted among said driving electrodes and polarized essentially in a vertical direction to said driving electrodes, and a power-generating section having a power-generating electrode with a second piezoelectric member, contacted between said first piezoelectric member and a power-generating electrode and polarized in the different direction from that of said first piezoelectric member.

### BACKGROUND OF THE INVENTION

A piezoelectric transformer of the above mentioned kind is basically a long-plate piezoelectric member. In the piezoelectric member, one pair of electrodes opposing each other in the thickness direction is formed on a portion including one end in the longitudinal direction of the piezoelectric member, and the piezoelectric member is polarized in the portion in the thickness direction. Another electrode is formed on the end face of the other portion including the other end in the longitudinal direction, and the piezoelectric member is polarized in the portion in the different direction from aforementioned direction i.e., the longitudinal direction. The former portion having one pair of electrodes opposing each other serves as a driving section or an input section. The latter portion serves as a power-generating section or an output section.
When an input voltage having a natural frequency determined by the dimension of the piezoelectric member in the longitudinal direction is applied between the electrodes of the driving section, which are disposed at one portion, the piezoelectric member generates strong mechanical vibration in the longitudinal direction due to an electrical deformation effect. Then, the piezoelectric member generates charges at the other portion due to the piezoelectric effect. These charges flow as an alternating high voltage between one of the electrodes in the driving section and the electrode of the power-generating section. In this way, the piezoelectric transformer causes a voltage rise through a conversion from electrical energy to mechanical energy and then a conversion from the mechanical energy to electrical energy.
In such a piezoelectric transformer, piezoelectric ceramic such as lead zirconate titanate is usually used as the piezoelectric member.
As a piezoelectric transformer having a relatively large voltage-rise ratio, a laminated piezoelectric transformer has been proposed. The laminated piezoelectric transformer has a piezoelectric member made of a laminated-layer member including a plurality of piezoelectric ceramic layers. A plurality of driving electrodes serving as input electrodes are formed such that an electrode opposes an adjacent electrode or adjacent electrodes through the piezoelectric ceramic. On extemal surfaces of the laminated-layer member, driving terminal electrodes and a power-generating terminal electrode are formed. A plurality of driving electrodes are electrically connected to the opposite terminal electrodes alternately. The power-generating terminal electrode serves as an output electrode.
Since the driving section and the power-generating section are polarized by using electrodes formed in the thickness and longitudinal directions for input and output in the above-described piezoelectric transformer, the degree of polarization is uniform both in the driving section and the power-generating section.

Therefore, the regulation of polarization in partial portion of the driving section and the power-generating section is difficult.

One problem caused by the above polarizing manner is that internal stress is generated at the boundary between the driving section and the power-generating section, in which the directions of polarization differ. As a result, the piezoelectric member may be destroyed by polarization, or a micro-crack may occur reducing the mechanical strength.

US-A-5,440,195 discloses a piezoelectric transformer with a driving section having a plurality of driving electrodes with a first piezoelectric member which is polarized essentially in a vertical direction to the driving electrodes and a power generating section having a power generating electrode with a second piezoelectric member being polarized in a different direction from that of the first piezoelectric member.

Patent abstracts of Japan, Volume 095, No. 010 corresponding to JP 07176805 A, patent abstracts of Japan, Volume 096, No. 006 corresponding to JP 08032137 A, patent abstracts of Japan, Volume 017, No. 466 (E-1421) corresponding to JP 05110368 A, and EP-A-0 720 246 disclose a piezoelectric transformer having the features of the preamble of claim 1.

EP-A-0 720 246 was published after the priority date of the present specification and, therefore, constitutes prior art only under Art. 54 (3) EPC.

### SUMMARY OF THE INVENTION

This invention seeks to provide a piezoelectric transformer of the above mentioned kind and a manufacturing method thereof, to achieve effective regulation of polarization and superior mechanical strength in which the generation of micro cracks and the destruction of the piezoelectric member due to generation of internal stress by polarization are suppressed.

This object is achieved with a piezoelectric transformer having the features of claim 1 and a method for manufacturing a piezoelectric transformer having the features of claim 9. Preferable embodiments form the subject matter of respective subclaims.

The first and second piezoelectric members preferably are made of ceramic, for example lead zirconate titanate.

According to the present invention, since the piezoelectric transformer is provided with at least one additional polarizing electrode, the degree of polarization in each partial area between the polarizing electrode and other electrodes of the piezoelectric transformer can be regulated respectively.

Specifically, when the polarizing electrode is provided with the second piezoelectric member, the second piezoelectric member can be polarized such that the degree of polarization between the driving section and the polarizing electrode closest to the driving section is lower than that of polarization between the power-generating electrode and the polarizing electrode closest to the driving section. When the polarizing electrode is provided with the first piezoelectric member, the first piezoelectric member can be polarized such that the degree of polarization among said polarizing electrodes closest to said power-generating section among said polarizing electrodes is lower than the degree of polarization among said driving electrodes.

Therefore, the generation of micro-cracks and the destruction of the piezoelectric member due to internal stress during polarization are suppressed. As a result, a piezoelectric transformer having superior mechanical strength is obtained.

### BRIEF DESCRIPTION OF THE DRAWINGS

- Fig. 1: is an exploded, perspective view of a non-burned laminated green compact used in a piezoelectric transformer according to a first embodiment of the present invention.
- Fig. 2: is a perspective view of a piezoelectric transformer having the laminated green compact shown in Fig. 1.
- Fig. 3: is a cross section taken on plane X-Y of the piezoelectric transformer shown in Fig. 2.
- Fig. 4: 4 is a cross section of a piezoelectric transformer according to a second embodiment of the present invention.
- Fig. 5: is a cross section of a piezoelectric transformer according to a third embodiment of the present invention.
- Fig. 6: is an exploded, perspective view of a non-burned laminated green compact used in a piezoelectric transformer according to a fourth embodiment of the present invention.
- Fig. 7: is a perspective view of a piezoelectric transformer having the laminated green compact shown in Fig. 6.
- Fig. 8: is a cross section taken on plane X-Y of the piezoelectric transformer shown in Fig. 7.

### DESCRIPTION OF THE PREFERRED EMBODIMENTS

Piezoelectric transformers according to embodiments of the present invention will be described below by referring to the drawings.

### First embodiment

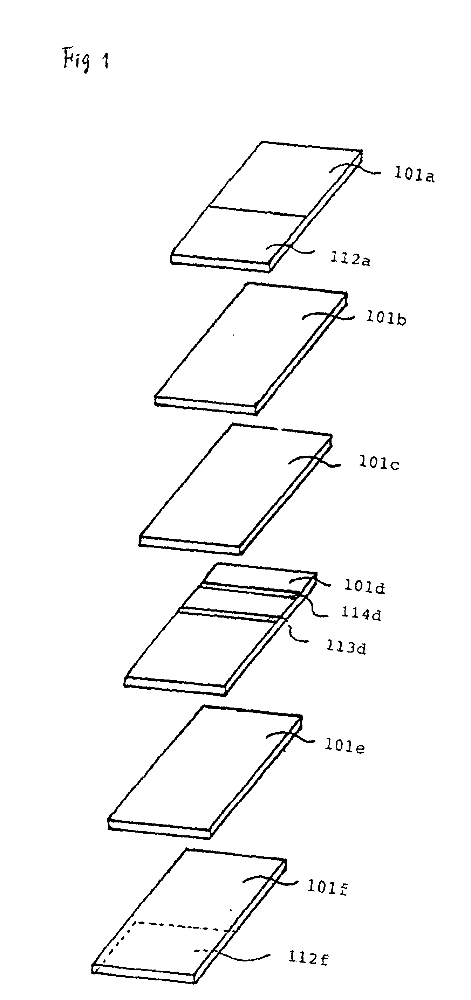

Fig. 1 is an exploded, perspective view of a non-burned laminated green compact used in a piezoelectric transformer in which a piezoelectric member is made of ceramic, according to a first embodiment of the present invention. In Fig. 1, there is shown green sheets 101a, 101b, 101c, 101d, 101e, and 101f made of a piezoelectric material, driving electrodes 112a and 112f, and electrodes 113d and 114d formed between the driving electrodes and a power-generating electrode. The electrodes are also assigned the same symbols after the piezoelectric member is burned.

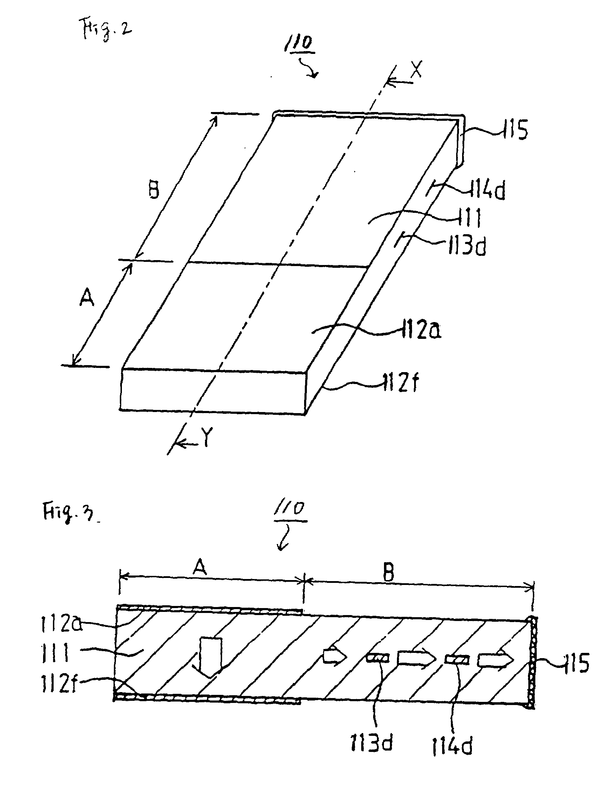

Fig. 2 is a perspective view of a piezoelectric transformer 10 having the laminated green compact shown in Fig. 1. In Fig. 2, there is shown a piezoelectric member 111, the power-generating electrode 115, a driving section A, and a power-generating section B. Since the other portions are the same as those shown in Fig. 1, the same symbols used in Fig. 1 are used and the description thereof is omitted.

Fig. 3 is a cross section taken from plane X-Y of the piezoelectric transformer 110 shown in Fig. 2. Since each portion is the same as that shown in Figs. 1 and 2, the same symbol used in Figs. 1 and 2 is used and the description thereof is omitted.

A manufacturing method of the piezoelectric transformer 110 shown in Figs. 2 and 3 will be described below by referring to Fig. 1.

The green sheets 101a, 101b, 101c, 101d, 101e, and 101f made of a piezoelectric material were firstly prepared. They were made by mixing Pb(Zr,Ti)O₃ ceramic powder with a binder and a solvent to make a paste and sheets were prepared using a doctor blade method.

At a portion including one end on the front surface of the green sheet 101a, the rectangular driving electrode 112a was formed by a screen printing method with the use of conductive paste comprising Ag/Pd for example, as an electrically conductive component. In the same way, almost-I-shaped electrodes 113d and 114d which extended to both sides of the green sheet 101d were formed perpendicularly to the longitudinal direction of the green sheet 101d on a portion including the other end on the front surface of the green sheet 101d. The rectangular driving electrode 112f was also formed by a screen printing method at a portion opposing the electrode 112a on the rear surface of the green sheet 101f.

As shown in Fig. 1, the green sheets 101f, 101e, 101d, 101c, 101b, and 101a were stacked in this order from the bottom and pressed to form a laminated green compact.

The laminated green compact was then sintered at 1100°C to form the piezoelectric member 111 having electrodes on the inside and outside as shown in Fig. 2. With the use of conductive paste having Ag as the main component, the power-generating electrode 115 was formed on the end face opposed to the end face near which the driving electrodes 112a and 112f of the piezoelectric member 111 were formed.

Then, the piezoelectric member obtained as described above was polarized in silicone oil. An electric field was applied to the first piezoelectric member via the driving electrodes 112a and 112f so that the first piezoelectric member was polarized in the thickness direction until the degree of polarization reached saturation. (The first piezoelectric member is a portion of the piezoelectric member 111 in the section A.)

An electric field was applied to a portion of the second piezoelectric member lying between the driving section and the polarizing electrode 113d via one electrode made by electrically short-circuiting the driving electrodes 112a and 112f, and the electrode 113d. This portion of the second piezoelectric member was polarized in the longitudinal direction to such an extent that the degree of polarization in the piezoelectric member did not reach saturation. (The second piezoelectric member is a portion of the piezoelectric member 111 in the section B.)

An electric field was applied to a portion of the second piezoelectric member lying between the polarizing electrodes 113d and 114d via these electrodes. This portion of the second piezoelectric member was polarized in the longitudinal direction until the degree of polarization in the piezoelectric member reached saturation. The direction of polarization is the same as that for the polarization between one electrode made by electrically short-circuiting the driving electrodes 112a and 112f, and the electrode 113d.

In the same way, an electric field was applied to a portion of the second piezoelectric member lying between the polarizing electrode 114d and the power-generating electrode 115 via these electrodes. This portion of the second piezoelectric member was also polarized in the longitudinal direction until the degree of polarization in the piezoelectric member reached saturation.

As described above, the piezoelectric transformer 110 according to the present invention was obtained in which the degree of polarization at a portion between the driving section (A) and the electrode 113d, which is the polarizing electrode closest to the driving section (A) among the polarizing electrodes provided in the power-generating section, is lower than that of polarization between the power-generating electrode and the polarizing electrode 113d. The piezoelectric transformer 110 measures 40 mm x 20 mm x 2 mm.

Mechanical strength was measured for the obtained piezoelectric transformer. Breakage-resistance strength of ten units for the piezoelectric transformer was measured in the thickness direction. The obtained data was plotted on Weibull probability paper to obtain the mean breaking strength (µ) and form factor (m). Table 1 shows the results.

### Second embodiment

In the same way as in the first embodiment, a piezoelectric transformer was prepared in which two sets of electrodes stacked in the thickness direction with the piezoelectric member made by laminated piezoelectric layers disposed therebetween were made in parallel between a driving section and an output electrode.

Fig. 4 is a cross section of the obtained piezoelectric transformer. In Fig. 4, there is shown a piezoelectric member 121, driving electrodes 122a and 122f, polarizing electrodes 123a, 123c, 123e, 123f, 124a, 124c, 124e, and 124f provided in a power-generating section, and a power-generating electrode 125.

The piezoelectric member was polarized in the following way.

An electric field was applied to the first piezoelectric member via the driving electrodes 122a and 122f so that the first piezoelectric member was polarized in the thickness direction until the degree of polarization reached saturation. (The first piezoelectric member is a portion of the piezoelectric member 121 in the section A.)

An electric field was applied to a portion of the second piezoelectric member lying between the driving section and the polarizing electrodes 123a, 123c, 123e and 123f via one electrode made by electrically short-circuiting the driving electrodes 122a and 122f, and the other electrode made by electrically short-circuiting the polarizing electrodes 123a, 123c, 123e, and 123f. The portion of the second piezoelectric member was polarized in the longitudinal direction to such extent that the degree of polarization did not reach saturation. (The second piezoelectric member is a portion of the piezoelectric member 121 in the section B.)

An electric field was applied to a portion of the second piezoelectric member lying between the one set of polarizing electrodes 123a, 123c, 123e and 123f, and the other set of polarizing electrodes 124a, 124c, 124e and 124f via one electrode made by electrically short-circuiting the polarizing electrodes 123a, 123c, 123e and 123f, and the other electrode made by electrically short-circuiting the polarizing electrodes 124a, 124c, 124e and 124f. The portion of the second piezoelectric member was polarized in the longitudinal direction to such extent that the degree of polarization reached saturation. The direction of polarization is the same as that for the polarization between one electrode made by electrically short-circuiting the driving electrodes 122a and 122f, and the other electrode made by electrically short-circuiting the electrodes 123a, 123c, 123e, and 123f.

In the same way, an electric field was applied to a portion of the second piezoelectric member lying between the one set of polarizing electrodes 124a, 124c, 124e and 124f, and the power-generating electrode 125 via one electrode made by electrically short-circuiting the polarizing electrodes 124a, 124c, 124e and 124f, and the power-generating electrode 125. The portion of the second piezoelectric member was polarized in the longitudinal direction to such extent that the degree of polarization reached saturation. The direction of polarization is also the same as that for the polarization between one electrode made by electrically short-circuiting the driving electrodes 122a and 122f, and the other electrode made by electrically short-circuiting the electrodes 123a, 123c, 123e, and 123f.

Mechanical strength was measured for the obtained piezoelectric transformer in the same way as in the first embodiment. Table 1 shows the results.

### Third embodiment

In the same way as in the first embodiment, a piezoelectric transformer was prepared in which a driving section is of laminated-layer type having a plurality of electrode layers, and three sets of electrodes stacked in the thickness direction with piezoelectric-member layers disposed therebetween were made in parallel between the driving section and a power-generating electrode.

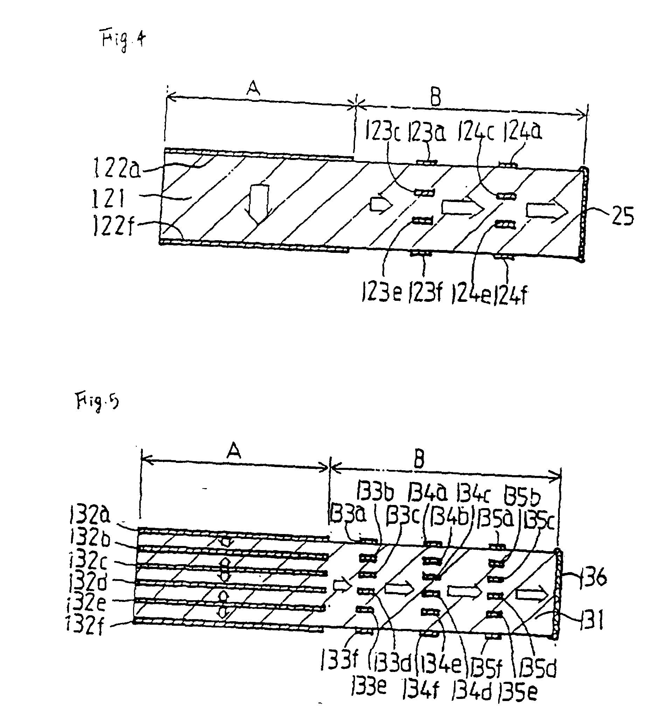

Fig. 5 is a cross section of the obtained piezoelectric transformer. In Fig. 5, there is shown a piezoelectric member 131, driving electrodes 132a, 132b, 132c, 132d, 132e, and 132f, polarizing electrodes 133a, 133b, 133c, 133d, 133e, 133f, 134a, 134b, 134c, 134d, 134e, 134f, 135a, 135b, 135c, 135d, 135e, and 135f formed in a power-generating section, and the power-generating electrode 136.

The piezoelectric member was polarized in the following way.

An electric field was applied to the first piezoelectric member via one electrode made by electrically short-circuiting the driving electrodes 132a, 132c and 132e and the other electrode made by electrically short-circuiting the driving electrodes 132b, 132d and 132f, so that the first piezoelectric member was polarized in the thickness direction until the degree of polarization reached saturation. (The first piezoelectric member is a portion of the piezoelectric member 131 in the section A.)

An electric field was applied to a portion of the second piezoelectric member lying between the driving section and the polarizing electrodes 133a, 133b, 133c, 133d, 133e and 133f via one electrode made by electrically short-circuiting the driving electrodes 132a, 132b, 132c, 132d and 132f, and the other electrode made by electrically short-circuiting the polarizing electrodes 133a, 133b, 133c, 133d, 133e and 133f. The portion of the second piezoelectric member was polarized in the longitudinal direction to such extent that the degree of polarization did not reach saturation. (The second piezoelectric member is a portion of the piezoelectric member 131 in the section B.)

An electric field was applied to a portion of the second piezoelectric member lying between the polarizing electrodes 133a, 133b, 133c, 133d, 133e and 133f and the polarizing electrodes 134a, 134b, 134c, 134d, 134e and 134f via one electrode made by electrically short-circuiting the polarizing electrodes 133a, 133b, 133c, 133d, 133e and 133f, and the other electrode made by electrically short-circuiting the polarizing electrodes 134a, 134b, 134c, 134d, 134e and 134f. The portion of the second piezoelectric member was polarized in the longitudinal direction to such extent that the degree of polarization reached saturation. The direction of polarization is the same as that for the polarization between one electrode made by electrically short-circuiting the polarizing electrodes 132a, 132b, 132c, 132d, 132e and 132f, and the other electrode made by electrically short-circuiting the polarizing electrodes 133a, 133b, 133c, 133d, 133e and 133f.

An electric field was applied to a portion of the second piezoelectric member lying between the polarizing electrodes 134a, 134b, 134c, 134d, 134e and 134f and the polarizing electrodes 135a, 135b, 135c, 135d, 135e and 135f via one electrode made by electrically short-circuiting the polarizing electrodes 134a, 134b, 134c, 134d, 134e and 134f, and the other electrode made by electrically short-circuiting the polarizing electrodes 135a, 135b, 135c, 135d, 135e and 135f. The portion of the second piezoelectric member was polarized in the longitudinal direction to such extent that the degree of polarization reached saturation. The direction of polarization is the same as that for the polarization between one electrode made by electrically short-circuiting the polarizing electrodes 132a, 132b, 132c, 132d, 132e and 132f, and the other electrode made by electrically short-circuiting the polarizing electrodes 133a, 133b, 133c, 133d, 133e and 133f.

In the same way, an electric field was applied to a portion of the second piezoelectric member lying between the one set of polarizing electrodes 135a, 135b, 135c, 135d, 135e and 135f, and the power-generating electrode 136 via one electrode made by electrically short-circuiting the polarizing electrodes 135a, 135b, 135c, 135d, 135e and 135f, and the power-generating electrode 136. The portion of the second piezoelectric member was polarized in the longitudinal direction to such extent that the degree of polarization reached saturation. The direction of polarization is also the same as that for the polarization between one electrode made by electrically short-circuiting the driving electrodes 122a and 122f, and the other electrode made by electrically short-circuiting the electrodes 123a, 123c, 123e, and 123f.

Mechanical strength was measured for the obtained piezoelectric transformer in the same way as in the first embodiment. Table 1 shows the results.

For comparison, a conventional piezoelectric transformer was prepared which had the same dimensions and the same electrode configuration as the piezoelectric transformer according to the third embodiment and which had a uniform degree of polarization in the driving section and a uniform degree of polarization in the power-generating section.

Mechanical strength was measured for the obtained conventional piezoelectric transformer in the same way as in the first embodiment. Table 1 shows the results.

**Table 1**

| | Mean breaking strength [µ] | Form factor [m] |
|---|---|---|
| Transformer according to first embodiment | 125,5 N/mm² (12,8 kgf/mm²) | 12.3 |
| Transformer according to second embodiment | 160,8 N/mm² (16,4 kgf/mm²) | 14.6 |
| Transformer according to third embodiment | 165,7 N/mm² (16,9 kgf/mm²) | 13.2 |
| Conventional transformer | 65,7 N/mm² (6,7 kgf/mm²) | 4.7 |

As shown in Table 1, the piezoelectric transformers according to the present invention has about double the mean breaking strength and a greatly reduced dispersion as indicated by the form factor as compared with the conventional piezoelectric transformer. This means that the piezoelectric transformers according to the present invention had no defects such as micro-cracks formed during polarization.

In the above embodiments, only a portion between the driving section and the electrodes closest to the driving section in the power-generating section among the electrodes formed between the driving section and the power-generating electrode is polarized to such an extent that the degree of polarization does not reach saturation. The degree of polarization may be gradually changed in the power-generating section from the driving section to the power-generating electrode.

### Fourth embodiment

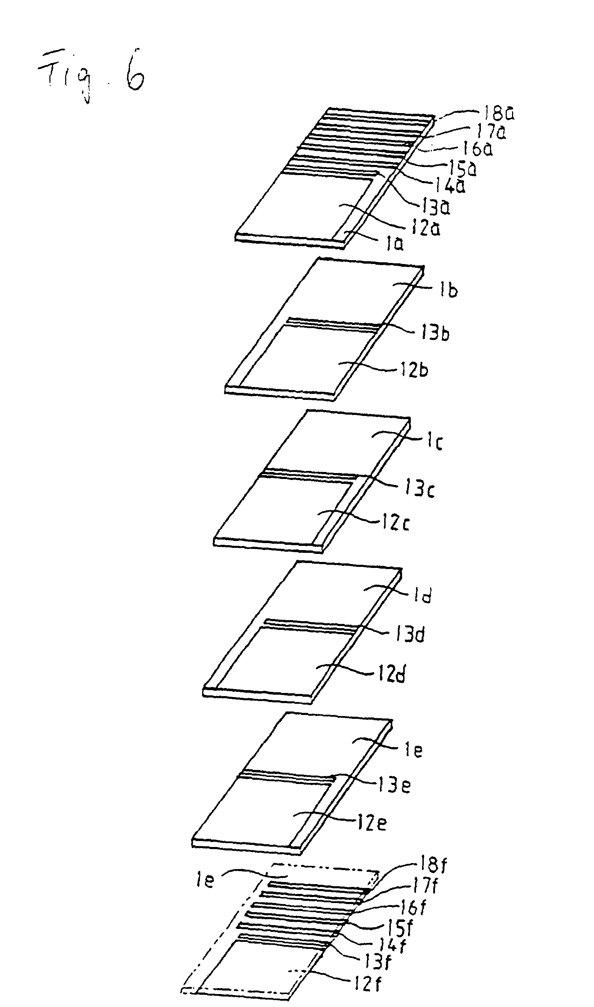

Fig. 6 is an exploded, perspective view of a non-burned laminated green compact used in a piezoelectric transformer in which a piezoelectric member is made of ceramic, according to an embodiment of the present invention. In Fig. 6, there is shown green sheets 1a, 1b, 1c, 1d, and 1e made of a piezoelectric material, driving electrodes 12a, 12b, 12c, 12d, 12e, and 12f, and polarizing electrodes 13a, 13b, 13c, 13d, 13e, 13f, 14a, 14f, 15a, 15f, 16a, 16f, 17a, and 17f. In the bottom section of the exploded view shown in Fig. 6, the green sheet 1e is made transparent in order to indicate the arrangement of the driving electrodes disposed on the lower surface of the green sheet 1e. The electrodes are also assigned the same symbols after the piezoelectric member is burned.

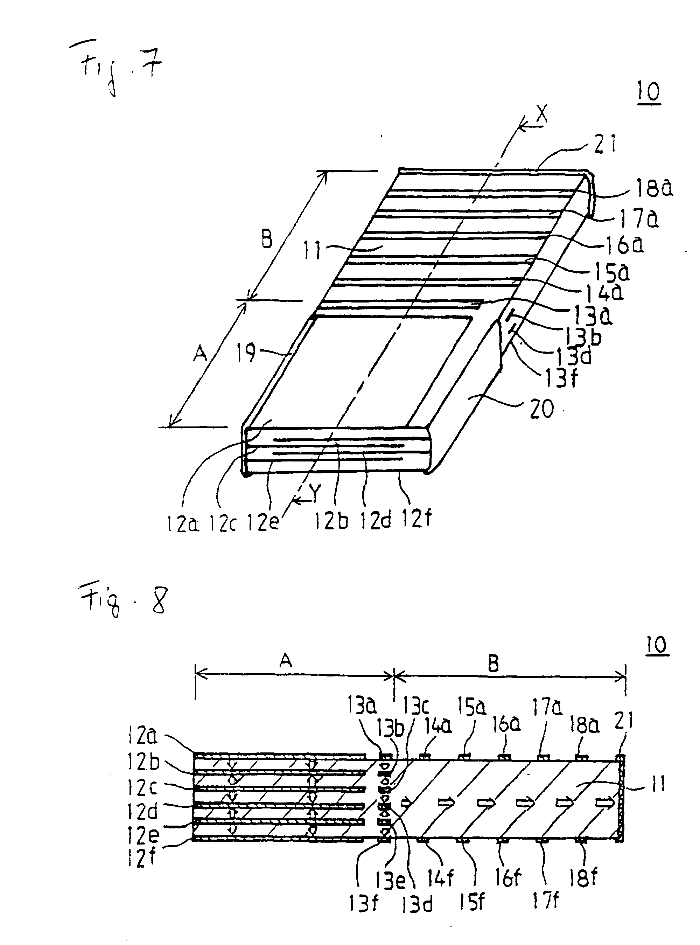

Fig. 7 is a perspective view of a piezoelectric transformer 10 having the laminated green compact shown in Fig. 6. In Fig. 7, there is shown a piezoelectric member 11, a driving section A, and a power-generating section B. There is also shown terminal electrodes 19 and 20 for the driving electrodes and a terminal electrode 21 for power generation. Since the other portions are the same as those shown in Fig. 6, the same symbols used in Fig. 6 are used and the description thereof is omitted.

Fig. 8 is a cross section taken from plane X-Y of the piezoelectric transformer 10 shown in Fig. 7. Since each portion is the same as that shown in Figs. 6 and 7, the same symbol used in Figs. 6 and 7 is used and the description thereof is omitted.

A manufacturing method of the piezoelectric transformer 10 shown in Figs. 7 and 8 will be described below by referring to Fig. 6. The green sheets 1a, 1b, 1c, 1d, and 1e made of a piezoelectric material were first prepared. They were made by mixing Pb(Zr,Ti)O₃ ceramic powder with a binder and a solvent to make a paste and sheets were prepared using a doctor blade method.

On the front surface of the green sheet 1a, the rectangular driving electrode 12a, almost-I-shaped polarizing electrodes 13a, 14a, 15a, 16a, 17a, and 18a were formed by a screen printing method with the use of conductive paste having Ag/pd as an electrically conductive component. The gap between the electrodes 12a and 13a was 1 mm and the gap between other adjacent electrodes was 2 mm. The electrodes had the shapes shown in Fig. 6.

In the same way, the driving electrode 12b and the polarizing electrode 13b were formed on the front surface of the green sheet 1b. The driving electrode 12c and the polarizing electrode 13c were formed on the front surface of the green sheet 1c. The driving electrode 12d and the polarizing electrode 13d were formed on the front surface of the green sheet 1d. The driving electrode 12e and the polarizing electrode 13e were formed on the front surface of the green sheet 1e.

On the rear surface of the green sheet 1e, the driving electrode 12f and the polarizing electrodes 13f, 14f, 15f, 16f, 17f, and 18f were formed. The gap between the electrodes 12f and 13f was 1 mm and the gap between other adjacent electrodes was 2 mm. The electrodes had the shapes shown in Fig. 6.

As shown in Fig. 6, the green sheets 1e, 1d, 1c, 1b, and 1a were stacked in this order from the bottom and pressed to form a laminated green compact.

The laminated green compact was then sintered at 1100°C to form the piezoelectric member 11 having electrodes on the inside and outside. With the use of conductive paste having Ag as the main component, the terminal electrode 19 electrically connected to the driving electrodes 12a, 12c, and 12e and the terminal electrode 20 electrically connected to the driving electrodes 12b, 12d, and 12f were formed on surfaces of the piezoelectric member 11. In addition, the terminal electrode 21 for power generation was formed at the end face of the power-generating section.

The piezoelectric member obtained as described above was polarized in silicone oil.

An electric field of 0.5 to 1.5 kV/mm, at 100 °C, was applied to a portion of the first piezoelectric member lying among the polarizing electrodes 13a∼13f in the driving section (A) in the vicinity of the power-generating section (B) via one electrode made by electrically short-circuiting the polarizing electrodes 13a, 13c, and 13e, and the other electrode made by electrically short-circuiting the polarizing electrodes 13b, 13d, and 13f. The portion of the first piezoelectric member was polarized in the thickness direction to such extent that the degree of polarization did not reach saturation. (The first piezoelectric member is a portion of the piezoelectric member 11 in the driving section A.)

The rest part of the first piezoelectric member was polarized until the degree of polarization in the thickness direction in the piezoelectric member reached saturation by applying an electric field of 2 to 5 kV/mm via the terminal electrodes 19 and 20 at 100 °C.

An electric field was applied to a portion of the second piezoelectric member lying between the polarizing electrodes 13a∼13f and the polarizing electrodes 14a and 14f via one electrode made by electrically short-circuiting the polarizing electrodes 13a∼13f, and the other electrode made by electrically short-circuiting the polarizing electrodes 14a and 14f. The portion of the second piezoelectric member was polarized in the longitudinal direction to such extent that the degree of polarization did not reach saturation. (The second piezoelectric member is a portion of the piezoelectric member 11 in the power-generating section B.)

An electric field was applied to a portion of the second piezoelectric member lying between the polarizing electrodes 14a and 14f, and the polarizing electrodes 15a and 15f via one electrode made by electrically short-circuiting the polarizing electrodes 14a and 14f, and the other electrode made by electrically short-circuiting the polarizing electrodes 15a and 15f. The portion of the second piezoelectric member was polarized in the longitudinal direction to such extent that the degree of polarization reached saturation. The direction of polarization is the same as that for the polarization between one electrode made by electrically short-circuiting the polarizing electrodes 13a∼13f, and the other electrode made by electrically short-circuiting the polarizing electrodes 14a and 14f.

In the same way, the piezoelectric member lying between the polarizing electrode 15a and 15f, and the polarizing electrode 16a and 16f was polarized until the degree of polarization reached saturation. The piezoelectric member lying between the polarizing electrode 16a and 16f, and the polarizing electrode 17a and 17f was polarized until the degree of polarization reached saturation. The piezoelectric member lying between the polarizing electrode 17a and 17f, and the polarizing electrode 18a and 18f was polarized until the degree of polarization reached saturation. The piezoelectric member lying between the polarizing electrode 18a and 18f, and the power-generating electrode 21 was polarized until the degree of polarization reached saturation.

As described above, the piezoelectric transformer 10 according to the present invention was obtained in which the degree of polarization at a portion among the polarizing electrode 13a∼13f in the driving section (A) in the vicinity of the power-generating section (B), and a portion between the polarizing electrodes 13a∼13f, and the polarizing electrodes 14a and 14f. The obtained piezoelectric transformer measured 40 mm x 20 mm x 2 mm as well.

For comparison, a conventional piezoelectric transformer was prepared which had the same dimensions and the same electrode configuration as the above-described piezoelectric transformer and which had a uniform degree of polarization in the driving section and a uniform degree of polarization in the power-generating section.

Mechanical strength was compared between the piezoelectric transformer according to the present invention and the conventional piezoelectric transformer. Breakage-resistance strength of ten units for each piezoelectric transformer was measured in the thickness direction. The obtained data was plotted on Weibull probability paper to obtain mean breaking strength (µ) and form factor (m). Table 2 shows the results.

**Table 2**

| | Mean breaking strength [µ] | Form factor [m] |
|---|---|---|
| Transformer according to first embodiment | 133,4 N/mm² (13,6 kgf/mm²) | 14.9 |
| Conventional transformer | 65,7 N/mm² (6,7 kgf/mm²) | 4.7 |

As shown in Table 2, the piezoelectric transformer according to the fourth embodiment of the present invention also has about double the mean breaking strength and a greatly reduced dispersion as indicated by the form factor as compared with the conventional piezoelectric transformer. This also means that the piezoelectric transformer according to the present invention had no defects such as micro-cracks formed during polarization.

In the fourth embodiment, the polarizing electrodes are left on the piezoelectric transformer. They may be removed from the surfaces of the piezoelectric member after polarization according to their use.

In the fourth embodiment, both driving section and power-generating section have areas with low degrees of polarization. Such an area may be provided for only one of the driving and the power-generating sections .

A piezoelectric transformer according to the present invention is not limited to that described in the above embodiment and may be modified in various ways within its scope. The positions, shapes, and number of driving electrodes, the positions, shapes, and number of electrodes used for polarization, and the position and shape of a power-generating terminal electrode can be changed as required.

The above embodiments has described the laminated piezoelectric transformer. A single-plate piezoelectric transformer may be used in which driving electrodes are formed on both surfaces opposing each other on a piezoelectric member.

In the above embodiments, in order to integrally form the piezoelectric transformer, a method is used in which laminated green sheets made of a piezoelectric material are sintered. Other methods may be used such as superposition of piezoelectric-member paste in printing and fusion of sintered members.

In the above embodiments, ceramic is used for the piezoelectric member. Other materials such as piezoelectric resin and a composite of ceramic and piezoelectric resin may be used.

## Claims

1. A piezoelectric transformer (10) comprising
a driving section (A) having a plurality of driving electrodes (12a-12f) and a first piezoelectric member, contacted among said driving electrodes (12a-12f) and polarized essentially in a vertical direction to said driving electrodes (12a-12f), and
a power-generating section (B) with a second piezoelectric member, contacted between said first piezoelectric member and a power-generating electrode (21) and polarized in a different direction from that of said first piezoelectric member,
said piezoelectric transformer (10) being provided with at least one additional polarizing electrode (13a-13f, 14a, 14f, 15a, 15f, 16a, 16f, 17a, 17f, 18a, 18f), and
said second piezoelectric member being equipped with at least one of said additional polarizing electrodes (14a, 14f, 15a, 15f, 16a, 16f, 17a, 17f, 18a, 18f),
**characterized in that**
the degree of polarization between said driving section (A) and said polarizing electrode (14a, 14f) closest to said driving section (A) is tower than the degree of polarization between said power-generating electrode (21) and said polarizing electrode (14a, 14f) closest to said driving section (A).

2. A piezoelectric transformer (10) according to claim 1,
**characterized in that**
said first piezoelectric member is equipped with at least one of said additional polarizing electrodes (13a-13f) in the vicinity of said power-generating section (B).

3. A piezoelectric transformer (10) according to claim 2,
**characterized in that**
the degree of polarization among polarizing electrodes (13a-13f), the first piezoelectric member is equipped with, and being closest to said power-generating section (B) is lower than the degree of polarization among said driving electrodes (12a-12f).

4. A piezoelectric transformer (10) according to one of claims 1 to 3,
**characterized in that**
said piezoelectric transformer (10) has a plate shape and is integrally formed, said driving section (A) being disposed at one portion including one end and said power-generating section (B) being disposed at the other portion including the other end,
said first piezoelectric member is polarized in the thickness direction of said piezoelectric transformer (10),
said second piezoelectric member is polarized in the longitudinal direction of said piezoelectric transformer (10), and
at least one of said additional polarizing electrodes (13a-13f, 14a, 14f, 15a, 15f, 16a, 16f, 17a, 17f, 18a, 18f) is exposed on a surface of said second piezoelectric member.

5. A piezoelectric transformer (10) according to one of claims 1 to 4,
**characterized in that**
at least one of said additional polarizing electrodes (14a, 14f, 15a, 15f, 16a, 16f, 17a, 17f, 18a, 18f) said second piezoelectric member is equipped with extends with its largest extension perpendicularly to the direction of polarization in said second piezoelectric member.

6. A piezoelectric transformer (10) according to one of claims 1 to 5,
**characterized in that**
said first and/or second piezoelectric member is equipped with a plurality of said additional polarizing electrodes (13a-13f, 14a, 14f, 15a, 15f, 16a, 16f, 17a, 17f, 18a, 18f) which are distributed in the thickness direction of said piezoelectric transformer (10) and in parallel with each other.

7. A piezoelectric transformer (10) according to one of claims 1 to 6,
**characterized in that**
said first piezoelectric member is equipped with a plurality of said driving electrodes (12a-12f) distributed in the thickness direction of said piezoelectric transformer (10) and in parallel with each other.

8. A piezoelectric transformer (10) according to one of claims 1 to 7,
**characterized in that**
said first and second piezoelectric members are made of ceramic.

9. A manufacturing method of a piezoelectric transformer (110) of one of claims 1 to 8, which comprises the steps of
1) polarizing a first portion of said first piezoelectric member by applying an electric field via said driving electrodes (112a, 112f),
2) polarizing a first portion of said second piezoelectric member between said driving section (A) and said additional polarizing electrode (113d) closest to said driving section by applying an electric field via said driving electrode (112a, 112f) and said additional polarizing electrode (113d, 114d),
3) polarizing a second portion of said second piezoelectric member between said power-generating electrode (115) and said additional polarizing electrode (113d) closest to said driving section (A) by applying an electric field via said power-generating electrode (115) and said additional polarizing electrodes (113d, 114d), such that the degree of polarization of said first portion of said second piezoelectric member is lower than the degree of polarization of said second portion of said second piezoelectric member.

10. A manufacturing method according to claim 9, which comprises the further step of
polarizing a second portion of said first piezoelectric member among said additional polarizing electrodes (13a-13f) closest to said power-generating section (B) by applying an electric field via said additional polarizing electrodes (13a-13f) closest to said power-generating section (B) such that the degree of polarization of said second portion of said first piezoelectric member is lower than the degree of polarization of said first portion of said first piezoelectric member.

## Patentansprüche

1. Piezoelektrischer Transformator (10), umfassend
einen Antriebsabschnitt (A) mit mehreren Antriebselektroden (12a - 12f) und einem ersten piezoelektrischen Element, das mit den Antriebselektroden (12a - 12f) Kontakt hat, und im Wesentlichen in eine vertikale Richtung zu den Antriebselektroden (12a - 12f) polarisiert ist, und
einen stromerzeugenden Abschnitt (B) mit einem zweiten piezoelektrischen Element, das mit dem ersten piezoelektrischen Element und einer stromerzeugenden Elektrode (21) Kontakt hat und in eine Richtung polarisiert ist, die sich von jener des ersten piezoelektrischen Elementes unterscheidet,
wobei der piezoelektrische Transformator (10) mit wenigstens einer zusätzlichen Polarisierungselektrode (13a - 13f, 14a, 14f, 15a, 15f, 16a, 16f, 17a, 17f, 18a, 18f) versehen ist, und
wobei das zweite piezoelektrische Element mit wenigstens einer der zusätzlichen Polarisierungselektroden (14a, 14f, 15a, 15f, 16a, 16f, 17a, 17f, 18a, 18f) ausgestattet ist,
**dadurch gekennzeichnet, dass**
der Grad der Polarisierung zwischen dem Antriebsabschnitt (A) und der Polarisierungselektrode (14a, 14f), die dem Antriebsabschnitt (A) am nächsten liegt, geringer ist als der Grad der Polarisierung zwischen der stromerzeugenden Elektrode (21) und der Polarisierungselektrode (14a, 14f), die dem Antriebsabschnitt (A) am nächsten liegt.

2. Piezoelektrischer Transformator (10) nach Anspruch 1,
**dadurch gekennzeichnet, dass**
das erste piezoelektrische Element mit wenigstens einer der zusätzlichen Polarisierungselektroden (13a - 13f) in der Nähe des stromerzeugenden Abschnittes (B) ausgestattet ist.

3. Piezoelektrischer Transformator (10) nach Anspruch 2,
**dadurch gekennzeichnet, dass**
der Grad der Polarisierung unter den Polarisierungselektroden (13a - 13f), mit welchen das erste piezoelektrische Elemente ausgestattet ist und die dem stromerzeugenden Abschnitt (B) am nächsten liegen, geringer ist als der Grad der Polarisierung unter den Antriebselektroden (12a - 12f).

4. Piezoelektrischer Transformator (10) nach einem der Ansprüche 1 bis 3,
**dadurch gekennzeichnet, dass**
der piezoelektrische Transformator (10) eine Plattenform hat und integral gebildet ist, wobei der Antriebsabschnitt (A) an einem Teil angeordnet ist, der ein Ende enthält, und der stromerzeugende Abschnitt (B) an dem anderen Teil angeordnet ist, der das andere Ende enthält,
wobei das erste piezoelektrische Element in die Dickenrichtung des piezoelektrischen Transformators (10) polarisiert ist,
wobei das zweite piezoelektrische Element in die Längsrichtung des piezoelektrischen Transformators (10) polarisiert ist, und
wenigstens eine der zusätzlichen Polarisierungselektroden (13a - 13f, 14a, 14f, 15a, 15f, 16a, 16f, 17a, 17f, 18a, 18f) an einer Oberfläche des zweiten piezoelektrischen Elementes freiliegt.

5. Piezoelektrischer Transformator (10) nach einem der Ansprüche 1 bis 4,
**dadurch gekennzeichnet, dass**
wenigstens eine der zusätzlichen Polarisierungselektroden (14a, 14f, 15a, 15f, 16a, 16f, 17a, 17f, 18a, 18f) des zweiten piezoelektrischen Elementes mit Verlängerungen versehen ist, wobei die größte Verlängerung senkrecht zu der Richtung der Polarisierung in dem zweiten piezoelektrischen Element ist.

6. Piezoelektrischer Transformator (10) nach einem der Ansprüche 1 bis 5,
**dadurch gekennzeichnet, dass**
das erste und/oder zweite piezoelektrische Element mit mehreren der zusätzlichen Polarisierungselektroden (13a - 13f, 14a, 14f, 15a, 15f, 16a, 16f, 17a, 17f, 18a, 18f) ausgestattet ist, die in die Dickenrichtung des piezoelektrischen Transformators (10) verteilt sind und parallel zueinander liegen.

7. Piezoelektrischer Transformator (10) nach einem der Ansprüche 1 bis 6,
**dadurch gekennzeichnet, dass**
das erste piezoelektrische Element mit mehreren Antriebselektroden (12a - 12f) ausgestattet ist, die in die Dickenrichtung des piezoelektrischen Transformators (10) verteilt sind und parallel zueinander liegen.

8. Piezoelektrischer Transformator (10) nach einem der Ansprüche 1 bis 7,
**dadurch gekennzeichnet, dass**
das erste und zweite piezoelektrische Element aus Keramik bestehen.

9. Herstellungsverfahren für einen piezoelektrischen Transformator (110) nach einem der Ansprüche 1 bis 8, welches folgende Schritte umfasst:
1) Polarisieren eines ersten Teiles des ersten piezoelektrischen Elementes durch Anlegen eines elektrischen Feldes über die Antriebselektroden (112a, 112f),
2) Polarisieren eines ersten Teiles des zweiten piezoelektrischen Elementes zwischen dem Antriebsabschnitt (A) und der zusätzlichen Polarisierungselektrode (113d), die dem Antriebsabschnitt am nächsten liegt, durch Anlegen eines elektrischen Feldes über die Antriebselektrode (112a, 112f) und die zusätzliche Polarisierungselektrode (113d, 114d),
3) Polarisieren eines zweiten Teiles des zweiten piezoelektrischen Elementes zwischen der stromerzeugenden Elektrode (115) und der zusätzlichen Polarisierungselektrode (113d), die dem Antriebsabschnitt (A) am nächsten liegt, durch Anlegen eines elektrischen Feldes über die stromerzeugende Elektrode (115) und die zusätzlichen Polarisierungselektroden (113d , 114d), so dass der Grad der Polarisierung des ersten Teiles des zweiten piezoelektrischen Elementes geringer als der Grad der Polarisierung des zweiten Teiles des zweiten piezoelektrischen Elementes ist.

10. Herstellungsverfahren nach Anspruch 9, das den weiteren Schritt umfasst:
Polarisieren eines zweiten Teiles des ersten piezoelektrischen Elementes von den zusätzlichen Polarisierungselektroden (13a - 13f), die dem stromerzeugenden Abschnitt (B) am nächsten sind, durch Anlegen eines elektrischen Feldes über die zusätzlichen Polarisierungselektroden (13a - 13f), die dem stromerzeugenden Abschnitt (B) am nächsten sind, so dass der Grad der Polarisierung des zweiten Teiles des ersten piezoelektrischen Elementes geringer als der Grad der Polarisierung des ersten Teiles des ersten piezoelektrischen Elementes ist.

## Revendications

1. Transformateur piézoélectrique (10) comprenant
une section de commande (A) ayant une pluralité d'électrodes de commande (12a à 12f) et un premier élément piézoélectrique, en contact parmi lesdites électrodes de commande (12a à 12f) et polarisées essentiellement dans une direction verticale auxdites électrodes de commande (12a à 12f), et
une section génératrice d'alimentation (B) avec un deuxième élément piézoélectrique, en contact entre ledit premier élément piézoélectrique et une électrode génératrice d'alimentation (21) et polarisée dans une direction différente de celle dudit premier élément piézoélectrique,
ledit transformateur piézoélectrique (10) étant muni d'au moins une électrode polarisante additionnelle (13a à 13f, 14a, 14f, 15a, 16a, 17a, 17f, 18a, 18f), et
ledit deuxième élément piézoélectrique étant équipé avec au moins une desdites électrodes polarisantes additionnelles (14a, 14f, 15a, 15f, 16a, 16f, 17a, 17f, 18a, 18f),
**caractérisé en ce que**
le degré de polarisation entre ladite section de commande (A) et ladite électrode polarisante (14a, 14f) le plus près de ladite section de commande (A) est plus faible que le degré de polarisation entre ladite électrode génératrice d'alimentation (21) et ladite électrode polarisante (14a, 14f) le plus près de ladite section de commande (A).

2. Transformateur piézoélectrique (10) selon la revendication 1,
**caractérisé en ce que**
on équipe ledit premier élément piézoélectrique avec au moins une desdites électrodes polarisantes additionnelles (13a à 13f) dans le voisinage de ladite section génératrice d'alimentation (B).

3. Transformateur piézoélectrique (10) selon la revendication 2,
**caractérisé en ce que**
le degré de polarisation parmi les électrodes polarisantes (13a à 13f), le premier élément piézoélectrique est équipé avec, et étant le plus près de ladite section génératrice d'alimentation (B) est plus faible que le degré de polarisation parmi lesdites électrodes de commande (12a à 12f).

4. Transformateur piézoélectrique (10) selon l'une des revendications 1 à 3,
**caractérisé en ce que**
ledit transformateur piézoélectrique (10) a une forme plate et est complètement formé, ladite section de commande (A) étant disposée à une partie comprenant une extrémité et ladite section génératrice d'alimentation (B) étant disposée à l'autre partie comprenant l'autre extrémité,
on polarise ledit premier élément piézoélectrique dans le sens de l'épaisseur dudit transformateur piézoélectrique (10),
on polarise ledit deuxième élément piézoélectrique dans le sens longitudinal dudit transformateur piézoélectrique (10), et
on expose au moins une desdites électrodes polarisantes additionnelles (13a à 13f, 14a, 14f, 15a, 15f, 16a, 16f, 17a, 18a, 18f) sur une surface dudit deuxième élément piézoélectrique.

5. Transformateur piézoélectrique (10) selon l'une des revendications 1 à 4,
**caractérisé en ce que**
on équipe au moins une desdites électrodes polarisantes additionnelles (14a, 14f, 15a, 15f, 16a, 16f, 17a, 17f, 18a, 18f) dudit deuxième élément piézoélectrique avec des prolongements avec son plus grand prolongement perpendiculaire au sens de polarisation dans ledit deuxième élément piézoélectrique.

6. Transformateur piézoélectrique (10) selon l'une des revendications 1 à 5,
**caractérisé en ce que**
on équipe ledit premier et/ou deuxième élément piézoélectrique avec une pluralité desdites électrodes polarisantes additionnelles (13a à 13f, 14a, 14f, 15a, 15f, 16a, 16f, 17a, 17f, 18a, 18f) que l'on distribue dans le sens de l'épaisseur dudit transformateur piézoélectrique (10) et en parallèle les unes par rapport aux autres.

7. Transformateur piézoélectrique (10) selon l'une des revendications 1 à 6,
**caractérisé en ce que**
on équipe ledit premier élément piézoélectrique avec une pluralité desdites électrodes de commande (12a à 12f) distribuées dans l'épaisseur dudit transformateur piézoélectrique (10) et en parallèle les unes par rapport aux autres.

8. Transformateur piézoélectrique (10) selon l'une des revendications 1 à 7,
**caractérisé en ce que**
lesdits premier et deuxième éléments piézoélectriques sont faits en céramique.

9. Procédé de fabrication d'un transformateur piézoélectrique (110) selon l'une des revendications 1 à 8, qui comprend les étapes de
1) polarisation d'une première partie dudit élément piézoélectrique en appliquant un champ électrique via lesdites électrodes de commande (112a, 112f),
2) polarisation d'une première partie dudit deuxième élément piézoélectrique entre ladite section de commande (A) et ladite électrode polarisante additionnelle (113d) la plus près de ladite section de commande en appliquant un champ électrique via ladite électrode de commande (112a, 112f) et ladite électrode polarisante additionnelle (113d, 114d)
3) polarisation d'une deuxième partie dudit deuxième élément piézoélectrique entre ladite électrode génératrice d'alimentation (115) et ladite électrode polarisante additionnelle (113d) la plus près de ladite section de commande (A) en appliquant un champ électrique via ladite électrode génératrice d'alimentation (115) et lesdites électrodes polarisantes additionnelles (113d, 114d), de telle façon que le degré de polarisation de ladite première partie dudit deuxième élément soit plus faible que le degré de polarisation de ladite deuxième partie dudit deuxième élément piézoélectrique.

10. Procédé de fabrication selon la revendication 9, qui comprend l'étape suivante de
polarisation d'une deuxième partie dudit premier élément piézoélectrique parmi lesdites électrodes polarisantes additionnelles (13a à 13f) la plus près de ladite section génératrice d'alimentation (B) en appliquant un champ électrique via lesdites électrodes polarisantes additionnelles (13a à 13f) le plus près de ladite section génératrice d'alimentation (B) de telle façon que le degré de polarisation de ladite deuxième partie dudit premier élément piézoélectrique est plus faible que le degré de polarisation de ladite première partie dudit premier élément piézoélectrique.
